# EUROPEAN PATENT APPLICATION

(11) **EP 4 651 631 A1**
(43) Date of publication of application: **19.11.2025**
(21) Application number: 23916279.5
(22) Date of filing: 25.12.2023
(51) Int. Cl.: H05H 1/46

(54) **PLASMA TREATMENT DEVICE AND PLASMA TREATMENT METHOD**

(30) Priority: 12.01.2023 JP 2023002993
(71) Applicant: Tokyo Electron Limited, Tokyo 107-6325 (JP)
(72) Inventor: HIGUCHI Ryuta, Kurokawa-gun, Miyagi 981-3629 (JP); SAITO Takehisa, Kurokawa-gun, Miyagi 981-3629 (JP); NAKAJIMA Toshiki, Kurokawa-gun, Miyagi 981-3629 (JP); KITAMURA Yuji, Kurokawa-gun, Miyagi 981-3629 (JP)
(74) Representative: Hoffmann Eitle
(86) International application number: PCT/JP2023/046507
(87) International publication number: WO 2024/150666

(57) **Abstract**

A plasma processing apparatus includes a chamber, a substrate support, at least one antenna, and a radio-frequency generator. The chamber includes a dielectric window. The dielectric window is between the substrate support and the antenna. The radio-frequency generator generates first radio-frequency power and second radio-frequency power. The first radio-frequency power has a first frequency. The second radio-frequency power has a second frequency. The dielectric window has a larger dielectric loss at the second frequency than at the first frequency.

## Description

### FIELD

Exemplary embodiments of the disclosure relate to a plasma processing apparatus and a plasma processing method.

### BACKGROUND

A plasma processing apparatus is used to perform plasma processing on substrates. The plasma processing apparatus includes a chamber, a substrate support, an antenna, a gas supply, and a radio-frequency (RF) power supply. The chamber includes a dielectric window. The substrate support is in the chamber. The antenna is external to the chamber. The dielectric window is between the substrate support and the antenna. The gas supply supplies a gas into the chamber. The RF power supply is electrically coupled to the antenna. The RF power supply provides RF power to the antenna. Patent Literature 1 describes an example of a plasma processing apparatus.

### CITATION LIST

### PATENT LITERATURE

Patent Literature 1: Japanese Unexamined Patent Application Publication No. 2011-119658

### BRIEF SUMMARY

### TECHNICAL PROBLEM

One or more aspects of the disclosure are directed to a technique for reducing wear of a dielectric window.

### SOLUTION TO PROBLEM

A plasma processing apparatus according to one exemplary embodiment includes a chamber, a substrate support, at least one antenna, a gas supply, and a radio-frequency generator. The chamber includes a dielectric window. The substrate support is in the chamber. The at least one antenna is external to the chamber. The dielectric window is between the substrate support and the at least one antenna. The gas supply supplies a gas into the chamber. The radio-frequency generator is electrically coupled to the at least one antenna. The radio-frequency generator generates first radio-frequency power and second radio-frequency power. The first radio-frequency power has a first frequency. The second radio-frequency power has a second frequency. The dielectric window has a larger dielectric loss at the second frequency than at the first frequency.

### ADVANTAGEOUS EFFECTS

The technique according to one exemplary embodiment reduces wear of the dielectric window.

### BRIEF DESCRIPTION OF DRAWINGS

FIG. 1 is a diagram of an inductively coupled plasma processing apparatus with an example structure.
FIG. 2 is a diagram of a power supply system and a control system in the plasma processing apparatus according to one exemplary embodiment.
FIG. 3 is a timing chart of first RF power and second RF power used in the plasma processing apparatus according to one exemplary embodiment.
FIG. 4 is a diagram of a power supply system and a control system in a plasma processing apparatus according to another exemplary embodiment.
FIG. 5A is a plan view of an antenna in one exemplary embodiment, FIG. 5B is a plan view of an antenna in another exemplary embodiment, and FIG. 5C is a plan view of an antenna in still another exemplary embodiment.
FIG. 6A is a diagram of an example power spectrum of RF power with multiple frequency components, FIG. 6B is a diagram of example measurement values representing the efficiency of the multiple frequency components in FIG. 6A for coupling with plasma, FIG. 6C is a diagram of an example power spectrum of RF power with multiple frequency components, and FIG. 6D is a diagram of example measurement values representing the efficiency of the multiple frequency components in FIG. 6C for coupling with plasma.
FIG. 7A is a diagram of an example power spectrum of second RF power with multiple frequency components, FIG. 7B is a diagram of example measurement values representing the efficiency of the multiple frequency components in FIG. 7A for coupling with plasma, and FIG. 7C is a diagram of an example power spectrum of the second RF power with multiple frequency components.
FIG. 8 is a flowchart of a plasma processing method according to one exemplary embodiment.

### DETAILED DESCRIPTION

Exemplary embodiments will now be described in detail with reference to the drawings. In the drawings, like reference numerals denote like or corresponding components.

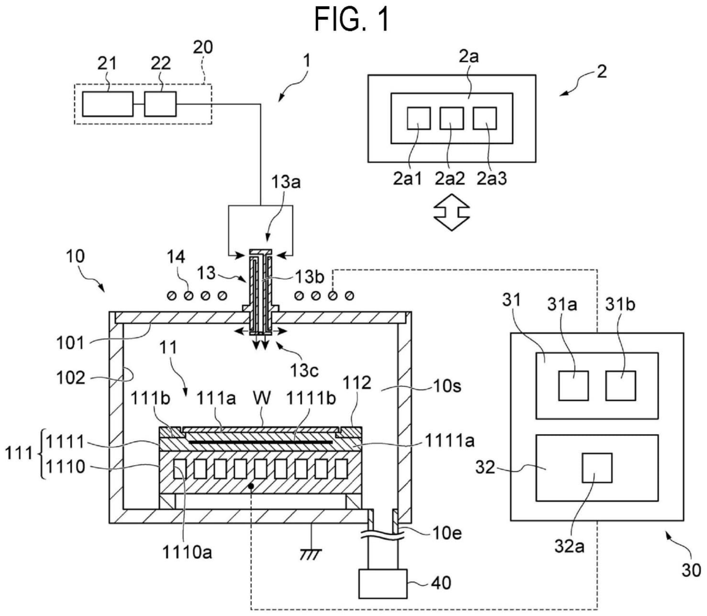

An example structure of a plasma processing system will now be described. FIG. 1 is a diagram of an inductively coupled plasma processing apparatus with an example structure.

The plasma processing system includes an inductively coupled plasma processing apparatus 1 and a controller 2. The inductively coupled plasma processing apparatus 1 includes a plasma processing chamber 10, a gas supply 20, a power supply 30, and an exhaust system 40. The plasma processing chamber 10 includes a dielectric window 101. The plasma processing apparatus 1 also includes a substrate support 11, a gas guide unit, and an antenna 14. The substrate support 11 is located in the plasma processing chamber 10. The antenna 14 is external to the chamber 10. The antenna 14 may be a coil wound around an axis extending in the vertical direction. The antenna 14 is located, for example, on or above the plasma processing chamber 10 (more specifically, on or above the dielectric window 101). The dielectric window 101 is located between the substrate support 11 and the antenna 14. The plasma processing chamber 10 has a plasma processing space 10s defined by the dielectric window 101, a sidewall 102 of the plasma processing chamber 10, and the substrate support 11. The plasma processing chamber 10 has at least one gas inlet for supplying at least one process gas into the plasma processing space 10s and at least one gas outlet for discharging the gas from the plasma processing space 10s. The plasma processing chamber 10 is grounded.

The substrate support 11 includes a body 111 and a ring assembly 112. The body 111 includes a central area 111a for supporting a substrate W and an annular area 111b for supporting the ring assembly 112. A wafer is an example of the substrate W. The annular area 111b of the body 111 surrounds the central area 111a of the body 111 as viewed in plan. The substrate W is placed on the central area 111a of the body 111. The ring assembly 112 is placed on the annular area 111b of the body 111 to surround the substrate W on the central area 111a of the body 111. Thus, the central area 111a is also referred to as a substrate support surface for supporting the substrate W. The annular area 111b is also referred to as a ring support surface for supporting the ring assembly 112.

In one embodiment, the body 111 includes a base 1110 and an electrostatic chuck (ESC) 1111. The base 1110 includes a conductive member. The conductive member in the base 1110 may serve as a bias electrode. The ESC 1111 is located on the base 1110. The ESC 1111 includes a ceramic member 1111a and an electrostatic electrode 1111b inside the ceramic member 1111a. The ceramic member 1111a includes the central area 111a. In one embodiment, the ceramic member 1111a also includes the annular area 111b. Another member surrounding the ESC 1111, such as an annular ESC or an annular insulating member, may include the annular area 111b. In this case, the ring assembly 112 may be located on either the annular ESC or the annular insulating member, or may be located on both the ESC 1111 and the annular insulating member. At least one radio-frequency (RF)/direct current (DC) electrode (described later) coupled to an RF power supply 31, a DC power supply 32, or both may be located inside the ceramic member 1111a. In this case, at least one RF/DC electrode serves as a bias electrode. The conductive member in the base 1110 and at least one RF/DC electrode may serve as multiple bias electrodes. The electrostatic electrode 1111b may also serve as a bias electrode. Thus, the substrate support 11 includes at least one bias electrode.

The ring assembly 112 includes one or more annular members. In one embodiment, one or more annular members include one or more edge rings and at least one cover ring. The edge ring is formed from a conductive material or an insulating material. The cover ring is formed from an insulating material.

The substrate support 11 may also include a temperature control module that adjusts the temperature of at least one of the ESC 1111, the ring assembly 112, or the substrate to be a target temperature. The temperature control module may include a heater, a heat transfer medium, a channel 1110a, or a combination of these. The channel 1110a allows a heat transfer fluid such as brine or gas to flow. In one embodiment, the channel 1110a is defined in the base 1110, and one or more heaters are located in the ceramic member 1111a in the ESC 1111. The substrate support 11 may include a heat transfer gas supply to supply a heat transfer gas into a space between the back surface of the substrate W and the central area 111a.

The gas guide unit introduces at least one process gas from the gas supply 20 into the plasma processing space 10s. In one embodiment, the gas guide unit includes a central gas injector (CGI) 13. The CGI 13 is located above the substrate support 11 and installed in a central opening in the dielectric window 101. The CGI 13 has at least one gas inlet 13a, at least one gas channel 13b, and at least one gas guide 13c. The process gas supplied to the gas inlet 13a passes through the gas channel 13b and is introduced into the plasma processing space 10s through the gas guide 13c. In addition to or in place of the CGI 13, the gas guide unit may include one or more side gas injectors (SGIs) installed in one or more openings in the sidewall 102.

The gas supply 20 may include at least one gas source 21 and at least one flow controller 22. In one embodiment, the gas supply 20 supplies at least one process gas from the corresponding gas source 21 to the gas guide unit through the corresponding flow controller 22. The flow controller 22 may include, for example, a mass flow controller or a pressure-based flow controller. The gas supply 20 may further include one or more flow rate modulators that allow supply of at least one process gas at a modulated flow rate or in a pulsed manner.

The power supply 30 includes an RF power supply 31 that is coupled to the plasma processing chamber 10 through at least one impedance matching circuit. The RF power supply 31 provides at least one RF signal (RF power) to at least one bias electrode and the antenna 14. This causes plasma to be generated from at least one process gas supplied into the plasma processing space 10s. The RF power supply 31 may thus at least partially serve as a plasma generator that generates plasma from one or more process gases in the plasma processing chamber 10. A bias RF signal is provided to at least one bias electrode to generate a bias potential in the substrate W, thus drawing ions in the plasma to the substrate W.

In one embodiment, the RF power supply 31 includes a first RF generator 31a and a second RF generator 31b. The first RF generator 31a (RF generator) is coupled to the antenna 14 and generates a source RF signal (source RF power) for generating plasma through at least one impedance matching circuit. In one embodiment, the source RF signal has a frequency in a range of 10 to 150 MHz. In one embodiment, the first RF generator 31a may generate multiple source RF signals with different frequencies. The generated one or more source RF signals are provided to the antenna 14.

The second RF generator 31b is coupled to at least one bias electrode through at least one impedance matching circuit and generates a bias RF signal (bias RF power). The bias RF signal may have a frequency that is the same as or different from the frequency of the source RF signal. In one embodiment, the bias RF signal has a lower frequency than the source RF signal. In one embodiment, the bias RF signal has a frequency in a range of 100 kHz to 60 MHz. In one embodiment, the second RF generator 31b may generate multiple bias RF signals with different frequencies. The generated one or more bias RF signals are provided to at least one bias electrode. In various embodiments, at least one of the source RF signal or the bias RF signal may be pulsed.

The power supply 30 may include the DC power supply 32 coupled to the plasma processing chamber 10. The DC power supply 32 includes a bias DC generator 32a. In one embodiment, the bias DC generator 32a is coupled to at least one bias electrode and generates a bias DC signal. The generated bias DC signal is applied to at least one bias electrode.

In various embodiments, the bias DC signal may be pulsed. In this case, a sequence of voltage pulses is applied to at least one bias electrode. The voltage pulses may have a rectangular, trapezoidal, triangular pulse waveform, or a combination of these pulse waveforms. In one embodiment, a waveform generator for generating a sequence of voltage pulses based on DC signals is coupled between the bias DC generator 32a and at least one bias electrode. Thus, the bias DC generator 32a and the waveform generator form a voltage pulse generator. The voltage pulses may have positive polarity or negative polarity. The sequence of voltage pulses may include one or more positive voltage pulses and one or more negative voltage pulses within one cycle. The power supply 30 may include the bias DC generator 32a in addition to the RF power supply 31. The bias DC generator 32a may replace the second RF generator 31b.

The exhaust system 40 is connectable to, for example, a gas outlet 10e in the bottom of the plasma processing chamber 10. The exhaust system 40 may include a pressure control valve and a vacuum pump. The pressure control valve regulates the pressure in the plasma processing space 10s. The vacuum pump may include a turbomolecular pump, a dry pump, or a combination of these.

The controller 2 processes computer-executable instructions that cause the plasma processing apparatus 1 to perform various steps described in one or more embodiments of the disclosure. The controller 2 may control the components of the plasma processing apparatus 1 to perform the various steps described herein. In one embodiment, some or all of the components of the controller 2 may be included in the plasma processing apparatus 1. The controller 2 may include a processor 2a1, a storage 2a2, and a communication interface 2a3. The controller 2 is implemented by, for example, a computer 2a. The processor 2a1 may perform various control operations by loading a program from the storage 2a2 and executing the loaded program. The program may be prestored in the storage 2a2 or may be obtained through a medium as appropriate. The obtained program is stored into the storage 2a2 to be loaded from the storage 2a2 and executed by the processor 2a1. The medium may be one of various storage media readable by the computer 2a, or a communication line connected to the communication interface 2a3. The processor 2a1 may be a central processing unit (CPU). The storage 2a2 may include a random-access memory (RAM), a read-only memory (ROM), a hard disk drive (HDD), a solid-state drive (SSD), or a combination of these. The communication interface 2a3 may communicate with the plasma processing apparatus 1 through a communication line such as a local area network (LAN).

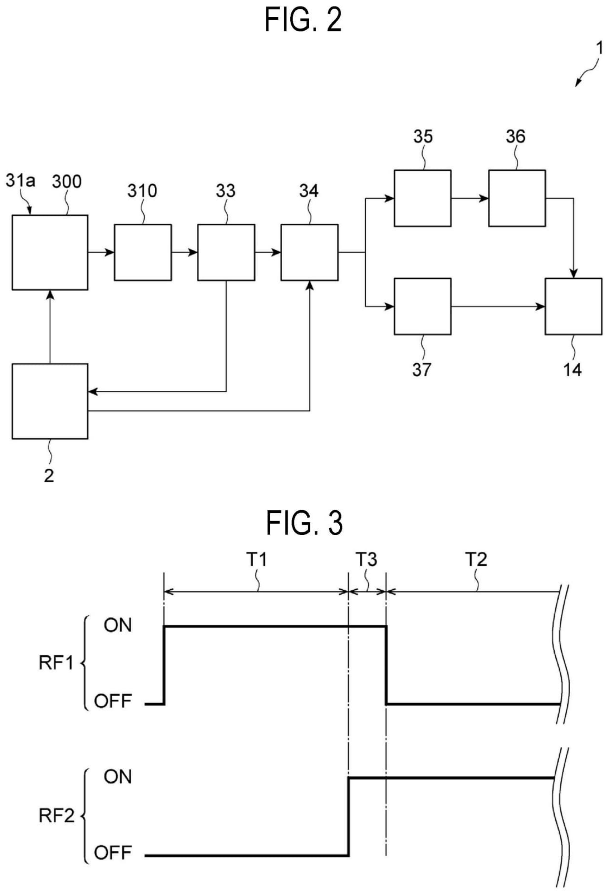

FIG. 2 will now be referred to. FIG. 2 is a diagram of a power supply system and a control system in the plasma processing apparatus according to one exemplary embodiment. As shown in FIG. 2, the plasma processing apparatus 1 may include the controller 2. In the plasma processing apparatus 1, the controller 2 may control the first RF generator 31a. In one embodiment, the first RF generator 31a may be a single RF power supply 300. The RF power supply 300 may include a signal generator and an amplifier. The signal generator outputs a signal with a frequency specified by the controller 2 to the amplifier. The amplifier amplifies the signal input from the signal generator to generate RF power and outputs the RF power. The amplifier may have an amplification rate specified by the controller 2.

The first RF generator 31a generates first RF power RF1 and second RF power RF2. The first RF power RF1 has a first frequency. The second RF power RF2 has a second frequency. The first frequency differs from the second frequency. For example, the second frequency may be higher than the first frequency by 1% or more.

The first RF generator 31a may be electrically coupled to the antenna 14 through a directional coupler 310, a sensor 33, and a matcher 34. The directional coupler 310 measures a power level of a traveling wave of the RF power (each of the first RF power RF1 and the second RF power RF2) output from the first RF generator 31a and a power level of a reflected wave of the RF power. The directional coupler 310 may determine, for example, a reflection coefficient of the RF power (each of the first RF power RF1 and the second RF power RF2) output from the RF power supply 300. The reflection coefficient is determined based on the power level of the traveling wave and the power level of the reflected wave. The reflection coefficient is provided from the directional coupler 310 to the controller 2. The directional coupler 310 may be integral with the RF power supply 300.

The sensor 33 is, for example, a voltage-current sensor. The sensor 33 measures a voltage and a current of the RF power (each of the first RF power RF1 and the second RF power RF2) to be provided to the antenna 14. The sensor 33 may determine a reflection coefficient of the RF power (each of the first RF power RF1 and the second RF power RF2) based on the measured voltage and current. The sensor 33 may provide the reflection coefficient to the controller 2.

The matcher 34 includes an impedance matching circuit including a variable impedance. The matcher 34 is coupled between the first RF generator 31a and the antenna 14. The matcher 34 matches a load impedance of the first RF generator 31a to an output impedance of the first RF generator 31a. The controller 2 may control the variable impedance of the matcher 34.

In one embodiment, the plasma processing apparatus 1 may further include a first filter 35, an impedance converter 36, and a second filter 37. The first filter 35 selectively passes the first RF power RF1. The second filter 37 selectively passes the second RF power RF2. The first filter 35 and the second filter 37 are coupled between the matcher 34 and the antenna 14 in parallel. The matcher 34, the first filter 35, and the antenna 14 define a first electric path. The first RF power RF1 is provided to the antenna 14 through the first electric path. The matcher 34, the second filter 37, and the antenna 14 define a second electric path. The second RF power RF2 is provided to the antenna 14 through the second electric path.

The impedance converter 36 is coupled between one of the first filter 35 or the second filter 37 and the antenna 14. In the example shown in FIG. 2, the impedance converter 36 is coupled between the first filter 35 and the antenna 14.

The matcher 34 may match a load impedance at the frequency of the RF power to be selectively passed through the other of the first filter 35 or the second filter 37 to the output impedance of the first RF generator 31a. In the example shown in FIG. 2, the matcher 34 matches a load impedance at the second frequency to the output impedance of the first RF generator 31a.

The impedance converter 36 matches a load impedance at the frequency of the RF power selectively passed through one of the first filter 35 or the second filter 37 to the output impedance of the first RF generator 31a. In the example shown in FIG. 2, the impedance converter 36 matches a load impedance at the frequency of the first RF power RF1 selectively passed through the first filter 35 to the output impedance of the first RF generator 31a. The impedance converter 36 may be a transformer.

The dielectric window 101 is formed from a material having a larger dielectric loss at the second frequency than at the first frequency in the dielectric window 101. In other words, the second frequency causes a larger dielectric loss in the dielectric window 101 than the first frequency. The first frequency and the second frequency may each be set for the material of the dielectric window 101. For example, the dielectric window 101 may be formed from a material having a largest dielectric loss at the second frequency. A frequency at which the dielectric loss of the material is maximized can be adjusted based on the type and concentration of dopant included in the material.

The first RF generator 31a generates the first RF power RF1. In one embodiment, the first RF generator 31a may generate the first RF power RF1 to ignite plasma in the chamber 10. The first RF power RF1 may be provided to the antenna 14 through the first electric path. The first RF generator 31a generates the second RF power RF2. In one embodiment, the first RF generator 31a may generate the second RF power RF2 to maintain the plasma ignited in the chamber 10. The second RF power RF2 may be provided to the antenna 14 through the second electric path.

When the dielectric window 101 has a smaller dielectric loss, the electrical energy coupled to the plasma is less likely to be lost. Thus, the plasma can be efficiently ignited in the chamber 10 by providing the first RF power RF1 to the antenna 14.

When the dielectric window 101 has a larger dielectric loss, the potential difference between the lower surface of the dielectric window 101 and the plasma is smaller, thus reducing the energy of ions striking the dielectric window 101 from the plasma. After the plasma is ignited, the second RF power RF2 is used to maintain the plasma. This can reduce wear of the dielectric window 101.

In the plasma processing apparatus 1, the matcher 34 matches a load impedance at one of the first frequency or the second frequency, and the impedance converter 36 matches a load impedance at the other frequency. Thus, the plasma processing apparatus 1 can simplify its power supply system.

FIG. 3 will now be referred to. FIG. 3 is a timing chart of the first RF power and the second RF power in the plasma processing apparatus according to one exemplary embodiment. The first RF generator 31a may simultaneously generate the first RF power RF1 and the second RF power RF2 after generating the first RF power RF1 alone and before generating the second RF power RF2 alone. In the embodiment, the first RF generator 31a simultaneously provides the first RF power RF1 and the second RF power RF2 to the antenna 14 after providing the first RF power RF1 alone to the antenna 14 and before providing the second RF power RF2 alone to the antenna 14. A period T3 during which the first RF power RF1 and the second RF power RF2 are simultaneously provided to the antenna 14 may be set after a period T1 during which the first RF power RF1 alone is provided to the antenna 14 and before a period T2 during which the second RF power RF2 alone is provided to the antenna 14.

In another embodiment, the first RF generator 31a may provide both the first RF power RF1 and the second RF power RF2 to the antenna 14 during the period T1. In this case, the second RF power RF2 has a lower power level during the period T1 than during the period T2. The first RF generator 31a may provide both the first RF power RF1 and the second RF power RF2 to the antenna 14 during the period T2. In this case, the first RF power RF1 has a lower power level during the period T2 than during the period T1. The first RF generator 31a may provide, to the antenna 14, the first RF power RF1 having a higher power level during the period T3 between the period T1 and the period T2 than during the period T2. The first RF power RF1 during the period T3 may have the same power level as the first RF power RF1 during the period T1. The first RF generator 31a may provide, to the antenna 14, the second RF power RF2 having a higher power level during the period T3 than during the period T1. The second RF power RF2 during the period T3 may have the same power level as the second RF power RF2 during the period T2.

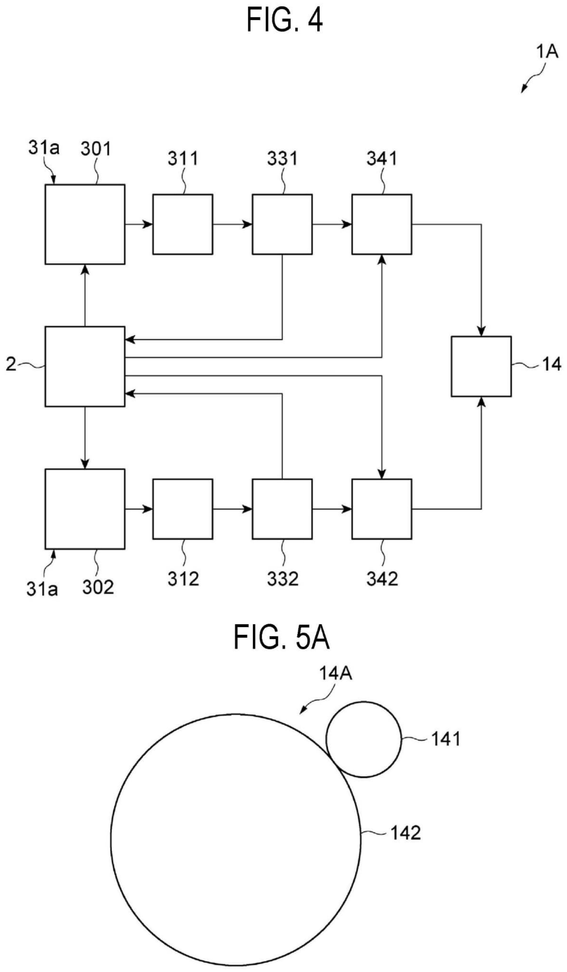

FIG. 4 will now be referred to. FIG. 4 is a diagram of a power supply system and a control system in a plasma processing apparatus according to another exemplary embodiment. A plasma processing apparatus 1A shown in FIG. 4 will now be described focusing on the differences from the power supply system and the control system in the plasma processing apparatus 1.

The first RF generator 31a in the plasma processing apparatus 1A includes multiple RF power supplies 301 and 302. The RF power supply 301 (first RF power supply) generates the first RF power RF1. The RF power supply 302 (second RF power supply) generates the second RF power RF2. The plasma processing apparatus 1A may not include the first filter 35, the impedance converter 36, or the second filter 37. The plasma processing apparatus 1A further includes a directional coupler 311, a sensor 331, a matcher 341, a directional coupler 312, a sensor 332, and a matcher 342.

The RF power supply 301 is electrically coupled to the antenna 14 through the directional coupler 311, the sensor 331, and the matcher 341. The matcher 341 matches a load impedance at the first frequency to an output impedance of the RF power supply 301.

The directional coupler 311 measures a power level of a traveling wave of the first RF power RF1 and a power level of a reflected wave of the first RF power RF1. The directional coupler 311 may determine a reflection coefficient of the first RF power RF1. The reflection coefficient is determined based on the power level of the traveling wave and the power level of the reflected wave. The reflection coefficient is provided from the directional coupler 311 to the controller 2. The directional coupler 311 may be integral with the RF power supply 301.

The sensor 331 is, for example, a voltage-current sensor. The sensor 331 measures a voltage and a current of the first RF power RF1 to be provided to the antenna 14. The sensor 331 may determine the reflection coefficient of the first RF power RF1 based on the measured voltage and current. The sensor 331 may provide the reflection coefficient to the controller 2.

The RF power supply 302 is electrically coupled to the antenna 14 through the directional coupler 312, the sensor 332, and the matcher 342. The matcher 342 matches a load impedance at the second frequency to an output impedance of the RF power supply 302.

The directional coupler 312 measures a power level of a traveling wave of the second RF power RF2 and a power level of a reflected wave of the second RF power RF2. The directional coupler 312 may determine a reflection coefficient of the second RF power RF2. The reflection coefficient is determined based on the power level of the traveling wave and the power level of the reflected wave. The reflection coefficient is provided from the directional coupler 312 to the controller 2. The directional coupler 312 may be integral with the RF power supply 302.

The sensor 332 is, for example, a voltage-current sensor. The sensor 332 measures a voltage and a current of the second RF power RF2 provided to the antenna 14. The sensor 332 may determine a reflection coefficient of the second RF power RF2 based on the measured voltage and current. The sensor 332 may provide the reflection coefficient to the controller 2.

FIGs. 5A to 5C will now be referred to. As shown in these figures, plasma processing apparatuses according to various exemplary embodiments may each include multiple antennas.

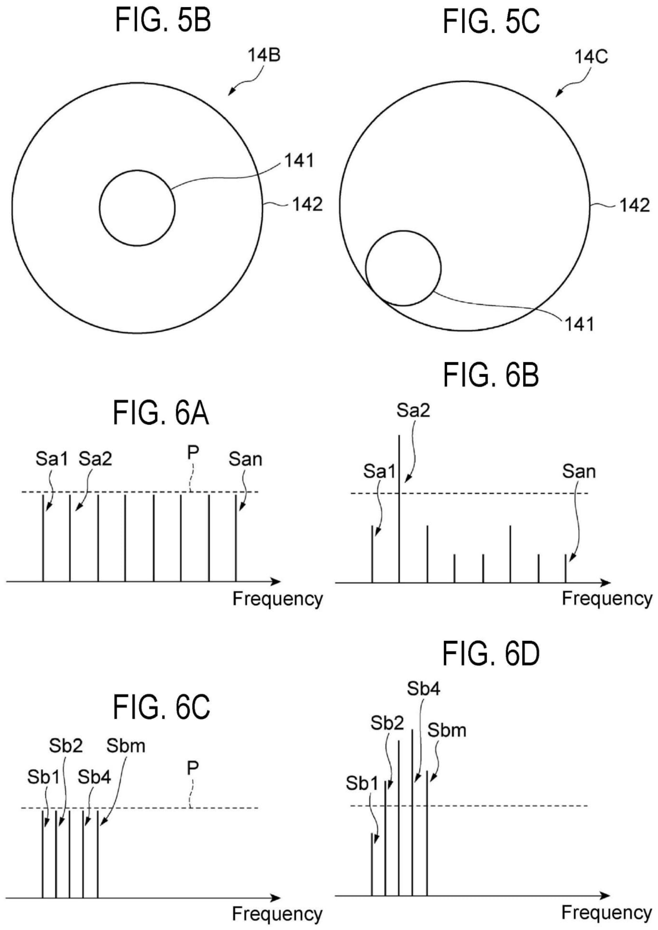

FIG. 5A is a plan view of an antenna in one exemplary embodiment. FIG. 5B is a plan view of an antenna in another exemplary embodiment. FIG. 5C is a plan view of an antenna in still another exemplary embodiment. Plasma processing apparatuses according to various exemplary embodiments may each include, in place of the antenna 14, an antenna 14A shown in FIG. 5A, an antenna 14B shown in FIG. 5B, or an antenna 14C shown in FIG. 5C.

Each of the antenna 14A, the antenna 14B, and the antenna 14C includes a first antenna 141 and a second antenna 142. The first antenna 141 and the second antenna 142 may each be a coil wound around an axis extending in the vertical direction. The first antenna 141 and the second antenna 142 are circular as viewed in plan. The second antenna 142 may have the central axis aligned with the central axis of the chamber 10. The first antenna 141 is smaller than the second antenna 142.

In the antenna 14A, the first antenna 141 and the second antenna 142 do not overlap each other as viewed in plan. In the antenna 14A, the outer circumference of the first antenna 141 may be externally in contact with the outer circumference of the second antenna 142 as viewed in plan.

In the antenna 14B, the first antenna 141 and the second antenna 142 overlap each other as viewed in plan. As shown in FIG. 5B, the first antenna 141 and the second antenna 142 may be coaxial with each other.

In the antenna 14C, the first antenna 141 and the second antenna 142 overlap each other as viewed in plan. As shown in FIG. 5C, the first antenna 141 has the central axis displaced from the central axis of the second antenna 142. The outer circumference of the first antenna 141 may be internally in contact with the inner circumference of the second antenna 142 as viewed in plan.

In each of the antenna 14A, the antenna 14B, and the antenna 14C, the first RF power RF1 alone of the first RF power RF1 and the second RF power RF2 may be provided to the first antenna 141. The second RF power RF2 alone of the first RF power RF1 and the second RF power RF2 may be provided to the second antenna 142. Both the first RF power RF1 and the second RF power RF2 may be provided to at least one of the first antenna 141 or the second antenna 142.

In one embodiment, the controller 2 may determine the first frequency to use the first RF power RF1 with the determined first frequency for plasma ignition. Processing performed by the controller 2 to determine the first frequency will now be described with reference to FIGs. 6A to 6D.

FIG. 6A is a diagram of an example power spectrum of RF power with multiple frequency components. The first RF generator 31a may generate the RF power with the multiple frequency components as shown in FIG. 6A. The RF power shown in FIG. 6A has multiple frequency components Sa1 to San, where n is an integer greater than or equal to 2. Each of the frequency components Sa1 to San has a predetermined power level P. The controller 2 controls the first RF generator 31a to provide the RF power with the multiple frequency components to the antenna 14. In the plasma processing apparatus 1A, the RF power supply 301 may generate the RF power with the multiple frequency components.

FIG. 6B is a diagram of example measurement values representing the efficiency of the multiple frequency components in FIG. 6A for coupling with plasma. The controller 2 uses the multiple measurement values to determine the first frequency. The measurement values represent the efficiency of the respective frequency components Sa1 to San for coupling with plasma. The measurement values may be, for example, reflection coefficients of the frequency components Sa1 to San obtained with the directional coupler 310 or the sensor 33, or with the directional coupler 311 or the sensor 331. The measurement values may be, for example, load power levels of the frequency components Sa1 to San obtained with the sensor 33 or the sensor 331. The load power levels are differences in power level between traveling waves and reflected waves of the respective frequency components Sa1 to San.

The controller 2 determines, using the measurement values, a frequency of a component having the highest efficiency for coupling with plasma among the frequency components Sa1 to San as a first frequency. In the example shown in FIG. 6B, the frequency component Sa2 has the highest efficiency for coupling with plasma among the frequency components Sal to San.

In one embodiment, the controller 2 may cause the first RF generator 31a to generate RF power including multiple frequency components Sb1 to Sbm having narrower frequency pitches than the frequency components Sa1 to San and update the first frequency. The controller 2 uses the first RF power RF1 with the updated first frequency for plasma ignition. In the plasma processing apparatus 1A, the RF power supply 301 may generate the RF power with the multiple frequency components.

FIG. 6C is a diagram of an example power spectrum of RF power with multiple frequency components. The RF power shown in FIG. 6C has multiple frequency components Sb1 to Sbm, where m is an integer greater than or equal to 2. Each of the frequency components Sb1 to Sbn has a predetermined power level P. The range including the frequency components Sb1 to Sbm is narrower than the range including the frequency components Sa1 to San. The range including the frequency components Sb1 to Sbm includes a frequency component having the highest efficiency for coupling with plasma among the frequency components Sa1 to San (e.g., frequency component Sa2). The frequency component Sa2 may be a center frequency in the range including the frequency components Sb1 to Sbm.

FIG. 6D is a diagram of example measurement values representing the efficiency of the multiple frequency components in FIG. 6C for coupling with plasma. The controller 2 uses the measurement values to update the first frequency. The measurement values represent the efficiency of the respective frequency components Sb1 to Sbn for coupling with plasma. The measurement values may be, for example, reflection coefficients of the frequency components Sb1 to Sbn obtained with the directional coupler 310 or the sensor 33, or with the directional coupler 311 or the sensor 331. The measurement values may be, for example, load power levels of the frequency components Sb1 to Sbn obtained with the sensor 33 or the sensor 331. The load power levels are differences in power level between traveling waves and reflected waves of the respective frequency components Sb1 to Sbn.

The controller 2 may determine a frequency of a component with the highest efficiency for coupling with plasma among the frequency components Sb1 to Sbn using the measurement values and update the first frequency to the determined frequency. In an example shown in FIG. 6D, a frequency component Sb4 has the highest efficiency for coupling with plasma among the frequency components Sb1 to Sbm.

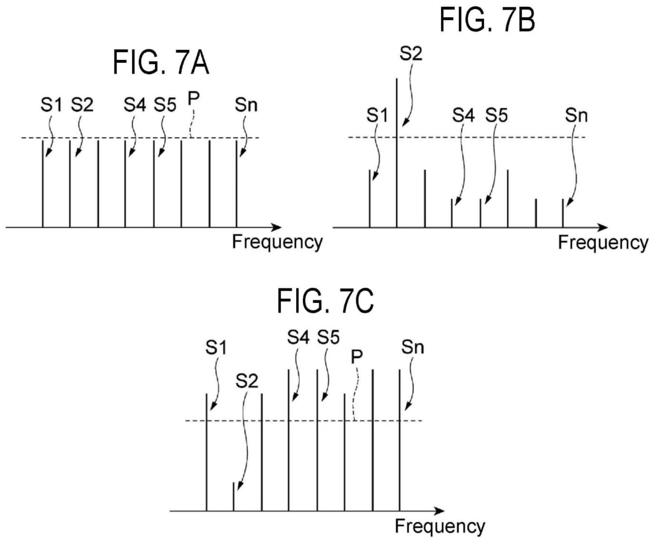

In one embodiment, after the plasma ignition, the controller 2 may maintain the plasma using the second RF power RF2 including multiple frequency components or may perform load power control of the multiple frequency components of the second RF power RF2. The load power control of the multiple frequency components of the second RF power RF2 performed by the controller 2 will now be described with reference to FIGs. 7A to 7C.

FIG. 7A is a diagram of an example power spectrum of the second RF power with multiple frequency components. After the plasma ignition, the first RF generator 31a may generate the second RF power with the multiple frequency components as shown in FIG. 7A. The second RF power shown in FIG. 7A has multiple frequency components S1 to Sn, where n is an integer greater than or equal to 2. Each of the frequency components S1 to Sn has a predetermined power level P. The controller 2 controls the first RF generator 31a to provide the second RF power with the multiple frequency components to the antenna 14. In the plasma processing apparatus 1A, the RF power supply 302 may generate the second RF power with the multiple frequency components.

FIG. 7B is a diagram of example measurement values of the multiple frequency components in FIG. 7A, representing the efficiency for coupling with plasma. The controller 2 uses the measurement values to perform the load power control of the multiple frequency components of the second RF power RF2. The measurement values represent the efficiency of the respective frequency components S1 to Sn for coupling with plasma. The measurement values may be, for example, reflection coefficients of the frequency components S1 to Sn obtained with the directional coupler 310 or the sensor 33, or with the directional coupler 312 or the sensor 332. The measurement values may be, for example, load power levels of the frequency components S1 to Sn obtained with the sensor 33 or the sensor 332. The load power levels are differences in power level between traveling waves and reflected waves of the respective frequency components S1 to Sn.

FIG. 7C is a diagram of an example power spectrum of the second RF power with multiple frequency components. The controller 2 adjusts load power levels of the multiple frequency components of the second RF power RF2 to be closer to respective specified load power levels using the measurement values as shown in FIG. 7C. In one example, the controller 2 may adjust the power levels of the multiple frequency components of the second RF power RF2 to be substantially the same.

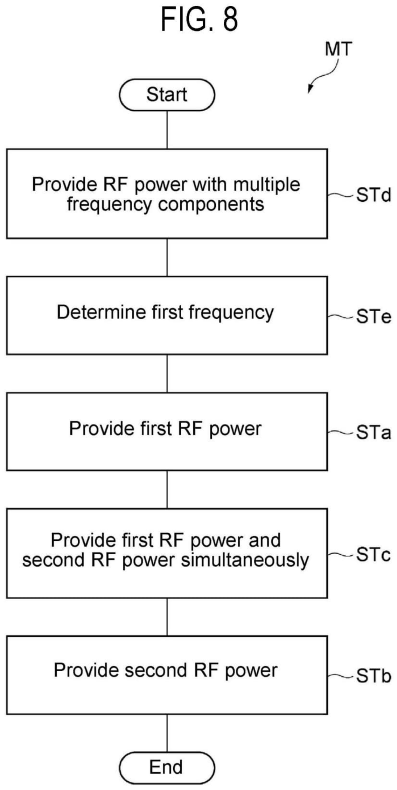

An example plasma processing method will now be described with reference to FIG. 8. FIG. 8 is a flowchart of a plasma processing method according to one exemplary embodiment. The plasma processing method (hereafter referred to as a method MT) shown in FIG. 8 may be performed with the plasma processing apparatus 1 or the plasma processing apparatus 1A. The method MT performed with the plasma processing apparatus 1 will now be described as an embodiment.

The method MT includes steps STa and STb. In step STa, the first RF power RF1 is provided from the first RF generator 31a to the antenna 14. In one embodiment, the first RF power RF1 may be provided from the first RF generator 31a to the antenna 14 to ignite the plasma in the chamber 10 in the plasma processing apparatus 1 in step STa. In step STb, the second RF power RF2 is provided from the first RF generator 31a to the antenna 14. In one embodiment, the second RF power RF2 may be provided from the first RF generator 31a to the antenna 14 to maintain the plasma ignited in the chamber 10 in step STb.

In one embodiment, when the method MT is performed with the plasma processing apparatus 1, the first RF power RF1 may be provided from the RF power supply 300 in step STa. The second RF power RF2 may be provided from the RF power supply 300 in step STb.

In one embodiment, when the method MT is performed with the plasma processing apparatus 1, the RF power may be selectively passed through the first filter 35 before being provided in step STa. The RF power selectively passed through the second filter 37 may be provided in step STb.

In one embodiment, when the method MT is performed with the plasma processing apparatus 1A, the first RF power RF1 may be provided from the RF power supply 301 in step STa. The second RF power RF2 may be provided from the RF power supply 302 in step STb.

In one embodiment, when the method MT is performed with a plasma processing apparatus including one of the antenna 14A, 14B, or 14C, the first RF power RF1 may be provided to the first antenna 141 in step STa. The second RF power RF2 may be provided to the second antenna 142 in step STb.

In one embodiment, the method MT may include step STc. In the example in FIG. 8, step STc is performed after step STa and before step STb. In this case, the first RF power RF1 alone is provided from the first RF generator 31a to the antenna 14 in step STa. In step STc, the first RF power RF1 and the second RF power RF2 are simultaneously provided from the first RF generator 31a to the antenna 14. The second RF power RF2 alone is provided from the first RF generator 31a to the antenna 14 in step STb.

In one embodiment, the method MT may include steps STd and STe. In the example in FIG. 8, steps STd and STe are performed before step STa. In step STd, the RF power with the multiple frequency components Sa1 to San is provided to the antenna 14 (refer to FIG. 6A).

In step STe, a frequency of a component having the highest efficiency for coupling with plasma among the frequency components Sa1 to San provided to the antenna 14 is determined as the first frequency. The first frequency is determined based on the measurement values (refer to FIG. 6B) representing the efficiency of the respective frequency components Sa1 to San for coupling with plasma. The measurement values may be, for example, reflection coefficients of the frequency components Sa1 to San obtained with the directional coupler 310 or the sensor 33, or with the directional coupler 311 or the sensor 331. The measurement values may be, for example, load power levels of the frequency components Sa1 to San obtained with the sensor 33 or the sensor 331. The load power levels are differences in power level between traveling waves and reflected waves of the respective frequency components Sa1 to San. The first RF power RF1 with the first frequency determined in step STe may be provided in step STa.

In one embodiment, step STd and step STe may be repeated. In this case, the RF power with the frequency components Sb1 to Sbm having narrower frequency pitches than the frequency components Sa1 to San may be provided to the antenna 14 in the repeated step STd (refer to FIG. 6C). In the repeated step STe, the first frequency is updated to a frequency of a component having the highest efficiency for coupling with plasma among the frequency components Sb1 to Sbm provided to the antenna 14. The first frequency is updated based on the measurement values (refer to FIG. 6D) representing the efficiency of the respective frequency components Sb1 to Sbm for coupling with plasma. The first RF power RF1 with the first frequency updated in the repeated step STe may be provided in step STa.

Although the exemplary embodiments have been described above, the embodiments are not restrictive, and various additions, omissions, substitutions, and changes may be made. The components in the different embodiments may be combined to form another embodiment.

Various exemplary embodiments E1 to E16 included in the disclosure will now be described.

### [E1]

A plasma processing apparatus, comprising:
a chamber including a dielectric window;
a substrate support in the chamber;
at least one antenna external to the chamber, the dielectric window being between the substrate support and the at least one antenna;
a gas supply configured to supply a gas into the chamber; and a radio-frequency generator electrically coupled to the at least one antenna, the radio-frequency generator being configured to generate first radio-frequency power with a first frequency and second radio-frequency power with a second frequency,
wherein the dielectric window has a larger dielectric loss at the second frequency than at the first frequency.

### [E2]

The plasma processing apparatus according to E1, wherein
the radio-frequency generator generates the first radio-frequency power to ignite plasma in the chamber, and
the radio-frequency generator generates the second radio-frequency power to maintain the plasma ignited in the chamber.

### [E3]

The plasma processing apparatus according to E1 or E2, wherein
the radio-frequency generator includes a single radio-frequency power supply.

### [E4]

The plasma processing apparatus according to any one of E1 to E3, further comprising:
a matcher coupled between the radio-frequency generator and the at least one antenna;
a first filter coupled between the matcher and the at least one antenna, the first filter being configured to selectively pass the first radio-frequency power;
a second filter coupled between the matcher and the at least one antenna, the second filter being configured to selectively pass the second radio-frequency power; and
an impedance converter coupled between one of the first filter or the second filter and the at least one antenna,
wherein the matcher matches, to an output impedance of the radio-frequency generator, a load impedance at a frequency of radio-frequency power selectively passed through the other of the first filter or the second filter, and
the impedance converter matches, to the output impedance of the radio-frequency generator, a load impedance at a frequency of radio-frequency power selectively passed through the one of the first filter or the second filter.

### [E5]

The plasma processing apparatus according to E1 or E2, wherein
the radio-frequency generator includes
a first radio-frequency power supply configured to generate the first radio-frequency power, and
a second radio-frequency power supply configured to generate the second radio-frequency power.

### [E6]

The plasma processing apparatus according to any one of E1 to E5, wherein
the at least one antenna includes
a first antenna configured to receive the first radio-frequency power, and
a second antenna configured to receive the second radio-frequency power.

### [E7]

The plasma processing apparatus according to any one of E1 to E6, wherein
the radio-frequency generator simultaneously provides the first radio-frequency power and the second radio-frequency power to the at least one antenna after providing the first radio-frequency power to the at least one antenna and before providing the second radio-frequency power to the at least one antenna.

### [E8]

The plasma processing apparatus according to any one of E1 to E7, further comprising:
a controller configured to control the radio-frequency generator to provide radio-frequency power with a plurality of frequency components to the at least one antenna, the controller being configured to determine a frequency of a component having highest efficiency for coupling with plasma among the plurality of frequency components to be the first frequency based on a plurality of measurement values obtained with a sensor, each of the plurality of measurement values representing efficiency of a corresponding frequency component of the plurality of frequency components for coupling with plasma.

### [E9]

A plasma processing method, comprising:
(a) providing first radio-frequency power with a first frequency from a radio-frequency generator to at least one antenna in a plasma processing apparatus, the plasma processing apparatus including
   a chamber including a dielectric window,
   a substrate support in the chamber,
   the at least one antenna external to the chamber, the dielectric window being between the substrate support and the at least one antenna, and
   the radio-frequency generator electrically coupled to the at least one antenna; and
(b) providing second radio-frequency power with a second frequency from the radio-frequency generator to the at least one antenna,
wherein the dielectric window has a larger dielectric loss at the second frequency than at the first frequency.

### [E10]

The plasma processing method according to E9, wherein
(a) includes providing the first radio-frequency power from the radio-frequency generator to the at least one antenna to ignite plasma in the chamber, and
(b) includes providing the second radio-frequency power from the radio-frequency generator to the at least one antenna to maintain the plasma ignited in the chamber.

### [E11]

The plasma processing method according to E9 or E10, wherein
the radio-frequency generator includes a single radio-frequency power supply,
(a) includes providing the first radio-frequency power from the single radio-frequency power supply, and
(b) includes providing the second radio-frequency power from the single radio-frequency power supply.

### [E12]

The plasma processing method according to any one of E9 to E11, wherein
the plasma processing apparatus further includes
   a matcher coupled between the radio-frequency generator and the at least one antenna,
   a first filter coupled between the matcher and the at least one antenna, the first filter being configured to selectively pass the first radio-frequency power,
   a second filter coupled between the matcher and the at least one antenna, the second filter being configured to selectively pass the second radio-frequency power, and
   an impedance converter coupled between one of the first filter or the second filter and the at least one antenna,
the matcher matches, to an output impedance of the radio-frequency generator, a load impedance at a frequency of radio-frequency power selectively passed through the other of the first filter or the second filter,
the impedance converter matches, to the output impedance of the radio-frequency generator, a load impedance at a frequency of radio-frequency power selectively passed through the one of the first filter or the second filter,
   (a) includes providing the radio-frequency power selectively passed through the first filter, and
   (b) includes providing the radio-frequency power selectively passed through the second filter.

### [E13]

The plasma processing method according to E9 or E10, wherein
the radio-frequency generator includes
a first radio-frequency power supply configured to generate the first radio-frequency power; and
a second radio-frequency power supply configured to generate the second radio-frequency power,

(a) includes providing the first radio-frequency power from the first radio-frequency power supply, and
(b) includes providing the second radio-frequency power from the second radio-frequency power supply.

### [E14]

The plasma processing method according to any one of E9 to E13, wherein
the at least one antenna includes
a first antenna configured to receive the first radio-frequency power, and
a second antenna configured to receive the second radio-frequency power,

(a) includes providing the first radio-frequency power to the first antenna, and
(b) includes providing the second radio-frequency power to the second antenna.

### [E15]

The plasma processing method according to any one of E9 to E14, further comprising:
(c) simultaneously providing the first radio-frequency power and the second radio-frequency power to the at least one antenna after providing the first radio-frequency power from the radio-frequency generator to the at least one antenna in (a) and before providing the second radio-frequency power from the radio-frequency generator to the at least one antenna in (b).

### [E16]

The plasma processing method according to any one of E9 to E15, further comprising:
(d) providing radio-frequency power with a plurality of frequency components to the at least one antenna; and
(e) determining a frequency of a component having highest efficiency for coupling with plasma among the plurality of frequency components to be the first frequency based on a plurality of measurement values obtained with a sensor, each of the plurality of measurement values representing efficiency of a corresponding frequency component of the plurality of frequency components for coupling with plasma,
wherein (a) includes providing the first radio-frequency power with the first frequency determined in (e) to the at least one antenna.

The exemplary embodiments according to the disclosure have been described by way of example, and various changes may be made without departing from the scope and spirit of the disclosure. The exemplary embodiments described above are thus not restrictive, and the true scope and spirit of the disclosure are defined by the appended claims.

### REFERENCE SIGNS LIST

1, 1A Plasma processing apparatus
2 Controller
10 Chamber
11 Substrate support
14, 14A, 14B, 14C Antenna
20 Gas supply
31a First RF generator
33, 331, 332 Sensor
34, 341, 342 Matcher
35 First filter
36 Impedance converter
37 Second filter
101 Dielectric window
300, 301, 302 RF power supply
310, 311, 312 Directional coupler
RF1 First RF power
RF2 Second RF power

## Claims

1. A plasma processing apparatus, comprising:
a chamber including a dielectric window;
a substrate support in the chamber;
at least one antenna external to the chamber, the dielectric window being between the substrate support and the at least one antenna;
a gas supply configured to supply a gas into the chamber; and
a radio-frequency generator electrically coupled to the at least one antenna, the radio-frequency generator being configured to generate first radio-frequency power with a first frequency and second radio-frequency power with a second frequency,
wherein the dielectric window has a larger dielectric loss at the second frequency than at the first frequency.

2. The plasma processing apparatus according to claim 1, wherein
the radio-frequency generator generates the first radio-frequency power to ignite plasma in the chamber, and
the radio-frequency generator generates the second radio-frequency power to maintain the plasma ignited in the chamber.

3. The plasma processing apparatus according to claim 1 or claim 2, wherein
the radio-frequency generator includes a single radio-frequency power supply.

4. The plasma processing apparatus according to claim 1 or claim 2, further comprising:
a matcher coupled between the radio-frequency generator and the at least one antenna;
a first filter coupled between the matcher and the at least one antenna, the first filter being configured to selectively pass the first radio-frequency power;
a second filter coupled between the matcher and the at least one antenna, the second filter being configured to selectively pass the second radio-frequency power; and
an impedance converter coupled between one of the first filter or the second filter and the at least one antenna,
wherein the matcher matches, to an output impedance of the radio-frequency generator, a load impedance at a frequency of radio-frequency power selectively passed through the other of the first filter or the second filter, and
the impedance converter matches, to the output impedance of the radio-frequency generator, a load impedance at a frequency of radio-frequency power selectively passed through the one of the first filter or the second filter.

5. The plasma processing apparatus according to claim 1, wherein
the radio-frequency generator includes
a first radio-frequency power supply configured to generate the first radio-frequency power, and
a second radio-frequency power supply configured to generate the second radio-frequency power.

6. The plasma processing apparatus according to claim 1 or claim 2, wherein
the at least one antenna includes
a first antenna configured to receive the first radio-frequency power, and
a second antenna configured to receive the second radio-frequency power.

7. The plasma processing apparatus according to claim 1 or claim 2, wherein
the radio-frequency generator simultaneously provides the first radio-frequency power and the second radio-frequency power to the at least one antenna after providing the first radio-frequency power to the at least one antenna and before providing the second radio-frequency power to the at least one antenna.

8. The plasma processing apparatus according to claim 1 or claim 2, further comprising:
a controller configured to control the radio-frequency generator to provide radio-frequency power with a plurality of frequency components to the at least one antenna, the controller being configured to determine a frequency of a component having highest efficiency for coupling with plasma among the plurality of frequency components to be the first frequency based on a plurality of measurement values obtained with a sensor, each of the plurality of measurement values representing efficiency of a corresponding frequency component of the plurality of frequency components for coupling with plasma.

9. A plasma processing method, comprising:
(a) providing first radio-frequency power with a first frequency from a radio-frequency generator to at least one antenna in a plasma processing apparatus, the plasma processing apparatus including
a chamber including a dielectric window,
a substrate support in the chamber,
the at least one antenna external to the chamber, the dielectric window being between the substrate support and the at least one antenna, and
the radio-frequency generator electrically coupled to the at least one antenna; and
(b) providing second radio-frequency power with a second frequency from the radio-frequency generator to the at least one antenna,
wherein the dielectric window has a larger dielectric loss at the second frequency than at the first frequency.

10. The plasma processing method according to claim 9, wherein
(a) includes providing the first radio-frequency power from the radio-frequency generator to the at least one antenna to ignite plasma in the chamber, and
(b) includes providing the second radio-frequency power from the radio-frequency generator to the at least one antenna to maintain the plasma ignited in the chamber.

11. The plasma processing method according to claim 9 or claim 10, wherein
the radio-frequency generator includes a single radio-frequency power supply,
(a) includes providing the first radio-frequency power from the single radio-frequency power supply, and
(b) includes providing the second radio-frequency power from the single radio-frequency power supply.

12. The plasma processing method according to claim 9 or claim 10, wherein
the plasma processing apparatus further includes
a matcher coupled between the radio-frequency generator and the at least one antenna,
a first filter coupled between the matcher and the at least one antenna, the first filter being configured to selectively pass the first radio-frequency power,
a second filter coupled between the matcher and the at least one antenna, the second filter being configured to selectively pass the second radio-frequency power, and
an impedance converter coupled between one of the first filter or the second filter and the at least one antenna,
the matcher matches, to an output impedance of the radio-frequency generator, a load impedance at a frequency of radio-frequency power selectively passed through the other of the first filter or the second filter,
the impedance converter matches, to the output impedance of the radio-frequency generator, a load impedance at a frequency of radio-frequency power selectively passed through the one of the first filter or the second filter,
(a) includes providing the radio-frequency power selectively passed through the first filter, and
(b) includes providing the radio-frequency power selectively passed through the second filter.

13. The plasma processing method according to claim 9 or claim 10, wherein
the radio-frequency generator includes
a first radio-frequency power supply configured to generate the first radio-frequency power; and
a second radio-frequency power supply configured to generate the second radio-frequency power,
(a) includes providing the first radio-frequency power from the first radio-frequency power supply, and
(b) includes providing the second radio-frequency power from the second radio-frequency power supply.

14. The plasma processing method according to claim 9 or claim 10, wherein
the at least one antenna includes
a first antenna configured to receive the first radio-frequency power, and
a second antenna configured to receive the second radio-frequency power,
(a) includes providing the first radio-frequency power to the first antenna, and
(b) includes providing the second radio-frequency power to the second antenna.

15. The plasma processing method according to claim 9 or claim 10, further comprising:
(c) simultaneously providing the first radio-frequency power and the second radio-frequency power to the at least one antenna after providing the first radio-frequency power from the radio-frequency generator to the at least one antenna in (a) and before providing the second radio-frequency power from the radio-frequency generator to the at least one antenna in (b).

16. The plasma processing method according to claim 9 or claim 10, further comprising:
(d) providing radio-frequency power with a plurality of frequency components to the at least one antenna; and
(e) determining a frequency of a component having highest efficiency for coupling with plasma among the plurality of frequency components to be the first frequency based on a plurality of measurement values obtained with a sensor, each of the plurality of measurement values representing efficiency of a corresponding frequency component of the plurality of frequency components for coupling with plasma,
wherein (a) includes providing the first radio-frequency power with the first frequency determined in (e) to the at least one antenna.
